Europäisches Patentamt

European Patent Office

Office européen des brevets

(11) Veröffentlichungsnummer: **0 230 278**
**A2**

(12) # EUROPÄISCHE PATENTANMELDUNG

(21) Anmeldenummer: **87100469.3**

(22) Anmeldetag: **15.01.87**

(51) Int. Cl.4: **H 01 L 31/10**

(30) Priorität: **24.01.86 DE 3602149**

(43) Veröffentlichungstag der Anmeldung:
**29.07.87 Patentblatt 87/31**

(84) Benannte Vertragsstaaten: **DE FR GB SE**

(71) Anmelder: **Siemens Aktiengesellschaft Berlin und München**
**Wittelsbacherplatz 2**
**D-8000 München 2 (DE)**

(72) Erfinder: **Sittig, Roland, Dr.**
**Lorenz-hagen-Weg 12**
**D-7000 München 83 (DE)**

(54) **Thyristor mit integrierter Stromversorgung für eine zugeordnete Schaltungseinheit und Verfahren zu seiner Herstellung.**

(57) Thyristor mit einem Ansatz (12) der n-Basis (3), der sich bis zur kathodenseitigen Grenzfläche (1a) des Halbleiterkörpers erstreckt und in dieser mit einer leitenden Belegung (13) versehen ist, die mit einer zugeordneten, mit Betriebsstrom zu versorgenden Schaltungseinheit (18) verbunden ist. Der Ansatz (12) weist einen ersten, an der Grenzfläche liegenden Teil (14) und einen zweiten Teil (15) kleineren Querschnitts auf, der zwischen dem ersten (14) und der n-Basis (3) liegt. Die Querschnittsabmessungen des ersten Teils (14) sind gegenüber den Abmessungen der leitenden Belegung (13) soweit vergrößert, daß diese mit der sich bei hohen Blockierspannungen ausbildenden, den zweiten Teil (15) weitgehend ausfüllenden Raumladungszone keinen Kontakt hat.

FIG 1

EP 0 230 278 A2

Bundesdruckerei Berlin

**Beschreibung**

Thyristor mit integrierter Stromversorgung für eine zugeordnete Schaltungseinheit und Verfahren zu seiner Herstellung

Die Erfindung bezieht sich auf einen Thyristor mit einer zugeordneten, mit Betriebsstrom zu versorgenden Schaltungseinheit nach dem Oberbegriff des Patentanspruchs 1 und auf Verfahren zu seiner Herstellung.

Ein Thyristor dieser Art ist aus der DE-A-32 26 613 bekannt. Dabei besteht die zugeordnete, mit Betriebsstrom zu versorgende Schaltungseinheit aus einem lichtempfindlichen Schaltelement, das zwischen die leitende Belegung und die kathodenseitige Elektrode geschaltet ist. Dieses Schaltelement, z.B. ein Fototransistor, weist eine relativ niedrige Sperrfähigkeit und eine damit zu vereinbarende, große Fotoempfindlichkeit auf, so daß das aus dem Thyristor und dem Schaltelement bestehende System sowohl eine große Zündempfindlichkeit als auch eine große Sperrfähigkeit besitzt. Nachteilig ist jedoch, daß die leitende Belegung bei hohen Blockierspannungen im Bereich der vom pn-Übergang zwischen den beiden Basisschichten ausgehenden, den Ansatz der n-Basis weitgehend ausfüllenden Raumladungszone liegt. Das führt zu Leckströmen, die unter Umständen eine ungewollte Zündung des Thyristors bewirken oder eine gewollte Zündung erschweren.

Der Erfindung liegt die Aufgabe zugrunde, einen Thyristor der eingangs genannten Art anzugeben, bei dem solche von der leitenden Belegung ausgehenden Leckströme weitgehend vermieden werden und eine sichere und kontrollierbare Stromversorgung der zugeordneten Schaltungseinheit erfolgt. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß die zugeordnete Schaltungseinheit in kontrollierbarer Weise mit den erforderlichen Betriebsgrößen versorgt wird, wobei sowohl die an der Schaltungseinheit liegende maximale Betriebsspannung als auch der ihr zugeführte maximale Betriebsstrom durch eine entsprechende Bemessung des zweiten Teiles des n-Emitter-Ansatzes vorgegeben werden.

Die Patentansprüche 2 bis 5 sind auf vorteilhafte Weiterbildungen und Ausgestaltungen der Erfindung gerichtet. Die Patentansprüche 6 und 7 betreffen vorteilhafte Verfahren zur Herstellung von Thyristoren nach der Erfindung.

Die Erfindung wird nachfolgend anhand von in der Zeichnung dargestellten, bevorzugten Ausführungsbeispielen näher erläutert. Dabei zeigt:

Fig. 1 ein erstes Ausführungsbeispiel der Erfindung mit einer zugeordneten Schaltungseinheit, die für eine Lichtzündung des Thyristors benötigt wird,

Fig. 2 ein Spannungsdiagramm zur Erläuterung von Fig. 1,

Fig. 3 ein zweites Ausführungsbeispiel mit einer die Signale eines Temperatursensors verarbeitenden Logikschaltung als zugeordnete Schaltungseinheit,

Fig. 4 eine strukturelle Modifizierung der Thyristoren nach den Figuren 1 oder 3 und

Fig. 5 eine weitere strukturelle Modifizierung der Thyristoren nach den Figuren 1 oder 3.

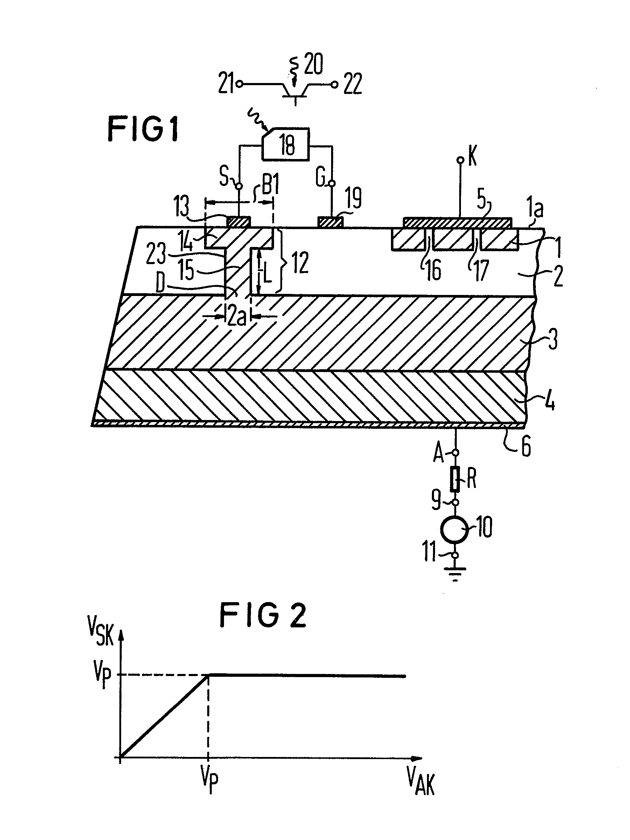

In Fig. 1 ist ein Thyristor mit einem Halbleiterkörper aus dotiertem Halbleitermaterial, z.B. Silizium, dargestellt, der vier aufeinanderfolgende Schichten abwechselnder Leitungstypen aufweist. Bei diesen handelt es sich um den n-Emitter 1, die p-Basis 2, die n-Basis 3 und den p-Emitter 4. Der n-Emitter 1 ist mit einer kathodenseitigen Elektrode 5 versehen, der p-Emitter 4 mit einer anodenseitigen Elektrode 6, wobei die Elektroden aus einem elektrisch leitenden Material, z.B. Aluminium, bestehen. Die Elektrode 5 ist über einen Anschluß K mit Masse verbunden, die Elektrode 6 über einen Anschluß A und einen Lastwiderstand R mit dem oberen Anschluß 9 einer Spannungsquelle 10, deren unterer Anschluß 11 auf Masse liegt.

Die n-Basis weist einen n-leitenden Ansatz 12 auf, der die p-Basis 2 durchdringt, sich bis zur Grenzfläche 1a des Halbleiterkörpers erstreckt und in dieser von einer leitenden Belegung 13 kontaktiert wird. Der Ansatz 12 setzt sich dabei aus einem ersten Teil 14 und einem zweiten Teil 15 zusammen, der zwischen dem Teil 14 und der n-Basis 3 angeordnet ist. Der in der Grenzfläche 1a betrachtete Querschnitt des Teiles 15 kann z.B. eine quadratische oder rechteckige Form haben, wobei die sichtbare Abmessung B1 größer bemessen ist als die hierzu parallele Abmessung der Belegung 13. Die senkrecht zur Bildebene gemessene Weite des Teils 14 ist ebenfalls größer bemessen als die Abmessung der Belegung 13 in dieser Richtung. Weiterhin sind die Querschnittsabmessungen des ebenfalls einen quadratischen oder rechteckigen Querschnitt aufweisenden zweiten Teiles 15, d.h. die in der Bildebene gemessene Tiefe 2a und die senkrecht zu ihr gemessene Weite Z, kleiner bemessen als die entspre chenden Abmessungen des Teils 14. Die Länge des Teils 15 sei hierbei mit L bezeichnet.

Der n-Emitter 1 ist mit Emitter-Basis-Kurzschlüssen versehen, die aus Ansätzen 16 und 17 der p-Basis 2 bestehen, welche den n-Emitter 1 durchdringen und in der Grenzfläche 1a von der Elektrode 5 kontaktiert werden. Die Belegung 13 hat einen Anschluß S, der mit dem ersten Anschluß einer dem Thyristor zugeordneten Schaltungseinheit 18 verbunden ist. Diese enthält ein lichtempfindliches Schaltelement, dem insbesondere eine Verstärkerstufe nachgeordnet ist. Im einfachsten Fall besteht 18, wie in Fig. 1 angedeutet, aus einem Fototransistor 20, dessen Anschlüsse 21 und 22 jeweils mit S und G verbunden werden, so daß die Anschlüsse S und G über die Schaltstrecke von 20 miteinander verbunden sind.

Der zweite Teil 15 des Ansatzes 12 kann als der Kanal eines Sperrschicht-Feldeffekttransistors (JFET) mit einer Kanaltiefe 2a, einer Kanallänge L und einer Kanalweite Z aufgefaßt werden, dessen Sourceanschluß durch S und dessen Drain durch die n-Basis 3 gebildet wird. Die den Kanal 15 umgebende p-Basis stellt ein Gategebiet dar, das von 19 kontaktiert wird und über den Anschluß G ansteuerbar ist. Über die Kurzschlüsse 16 und 17 liegt G stets auf dem Massepotential der kathodenseitigen Elektrode 5.

Nimmt man an, daß das lichtempfindliche Schaltelement der Schaltungseinheit 18 nicht beleuchtet wird, so ist die Verbindung zwischen S und G sehr hochohmig. Läßt man dabei die Anodenspannung $V_{AK}$ von Null in Richtung auf positive Werte ansteigen, so entspricht das Potential am Anschluß S und an einem Punkt D, der etwa den Übergang zwischen dem Kanal 15 und der n-Basis 3 kennzeichnet, zunächst der Spannung $V_{AK}$. Erreicht $V_{AK}$ einen Wert $V_P$, bei dem der gesamte Querschnitt des Kanals 15 von der Raumladungszone, die sich am pn-Übergang 23 zwischen dem Ansatz 12 und der p-Basis 2 aufbaut, ausgefüllt ist, so liegen auch die Schaltungspunkte S und D auf $V_P$. Ein weiterer Anstieg von $V_{AK}$, z.B. auf 5000 Volt und darüber, beeinflußt dann die Spannung an S und D nicht mehr. Trägt man die Spannung $V_{SK}$, die zwischen den Anschlüssen S und K gemessen werden kann, über der Anodenspannung $V_{AK}$ auf, so kann dieser Sachverhalt gemäß Fig. 2 veranschaulicht werden.

Der Wert von $V_P$ kann, wie dem Buch von S.M.Sze "Physics of Semiconductor Devices", Wiley & Sons, New York, 1969, vgl. S. 340-351, entnehmbar ist, durch entsprechende Wahl der Dotierungskonzentration $N_D$ des Ansatzes 12 und der halben Kanaltiefe a gemäß der Beziehung

$$V_P = \frac{q \cdot N_D \cdot a^2}{2 \cdot \varepsilon_S} \qquad (1)$$

festgelegt werden. Dabei stellt 2 die Elementarladung und $\varepsilon_s$ die Dielektrizitätskonstante des Halbleitermaterials dar. Mit $N_D = 2.10^{13}$ cm$^{-3}$ und a = 5.10$^{-3}$ cm ergibt sich für $V_P$ beispielsweise ein Wert von etwa 40 Volt.

Werden bei einer $V_P$ übersteigenden Anodenspannung $V_{AK}$ die Anschlüsse S und G niederohmig miteinander verbunden, so bedeutet das für den JFET eine Drainspannung $V_D = V_P$ und eine Gatespannung $V_G = 0$ (jeweils auf S bezogen). Dabei fließt der maximale Drainstrom $I_{DSat}$:

$$I_{DSat} = I_P \left[ 1 - 3 \frac{V_{bi}}{V_P} + 2 \left( \frac{V_{bi}}{V_P} \right)^{3/2} \right] \doteq 0{,}95 \, I_P \quad (2)$$

Für $I_P$ gilt die Beziehung

$$I_P = \frac{2 Z \mu q^2 N_D^2 a^3}{6 \varepsilon_S L} \qquad (3)$$

Dabei bedeuten $V_{bi}$ die eingeprägte Spannung am pn-Übergang zwischen den Teilen 2 und 15 und $\mu$ die Ladungsträgerbeweglichkeit im Kanal 15. $I_P$ kann durch die Kanalweite Z des Teils 15 unabhängig eingestellt werden. Mit den obigen Werten und Z = 0,3 cm sowie L = 5.10$^{-3}$ cm ergibt sich beispielsweise für $I_P$ ein Wert von etwa 25 mA.

In der Struktur nach Fig. 1 hat der Ansatz 12 die Bedeutung eines integrierten Stromversorgungsteils, der die Schaltungseinheit 18 beim Ansteigen von $V_{AK}$ über $V_P$ hinaus maximal mit einem Betriebsstrom $I_{DSat}$ versorgen kann. Wird also das lichtempfindliche Schaltelement in 18 beleuchtet, so fließt bei der beschriebenen Strukturauslegung ein Drainstrom, der je nach Lichtintensität und Verstärkungsfaktor der Schaltungseinheit 18 bis zu 25 mA betragen kann. Dieser wird dem Anschluß G der Zündelektrode 19 als Zündstrom zugeführt. Die Lichtenergie, die der Schaltungseinheit 18 hierbei zur Auslösung der Zündung zugeführt wird, ist wesentlich geringer als die, die dem Thyristor zur direkten Lichtzündung zugeführt werden müßte.

Die Querschnittsabmessungen des ersten Teils 14 des Ansatzes 12 sind größer gewählt als die Abmessungen der Belegung 13, weil dadurch gewährleistet ist, daß die Belegung 13 nicht mit der sich am pn-Übergang 23 ausbildenden Raumladungszone in Kontakt kommt. Auf diese Weise können störende Leckströme vermieden werden.

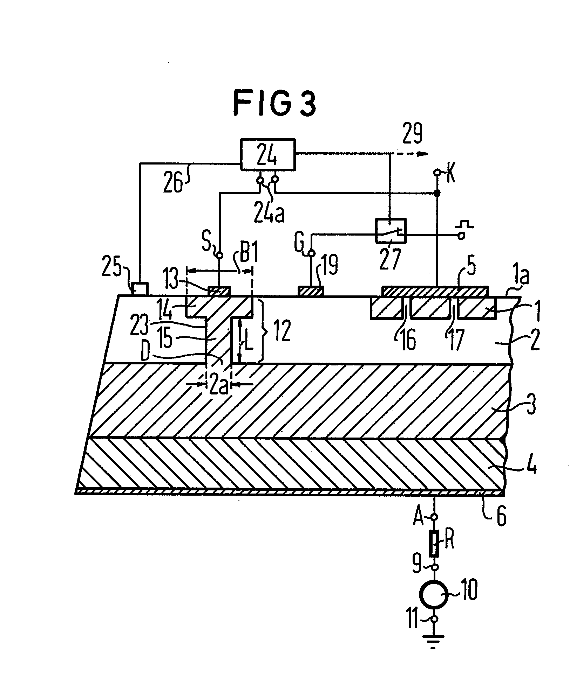

Fig. 3 zeigt ein anderes Ausführungsbeispiel der Erfindung, das der Halbleiterstruktur nach Fig. 1 vollständig entspricht, sich jedoch durch eine unterschiedliche Beschaltung von S, G und K von Fig. 1 unterscheidet. Im einzelnen ist hier eine dem Thyristor zugeordnete Schaltungseinheit 24 vorgesehen, die über den integrierten Stromversorgungsteil 12 aus dem bei A und K angeschlossenen Laststromkreis mit Betriebsstrom versorgt wird. 24 bezeichnet eine Logikschaltung, die mit einem an der Grenzfläche 1a angebrachten Temperatursensor 25 über eine Leitung 26 verbunden ist. Der Temperatursensor 25 liefert z.B. ein Signal, wenn der Halbleiterkörper des Thyristors eine maximal zulässige Temperatur erreicht oder überschritten hat. Dieses Signal wird in 24 zu einem Schaltsignal verarbeitet, das einen elektronischen Schalter 27 öffnet, so daß ein Zündstromimpuls 28, der von einem nicht dargestellten Zündstromkreis geliefert wird, nicht mehr zum Anschluß G gelangt. Somit unterbleibt eine Zündung des Thyristors so lange, bis seine Temperatur wieder unter den maximal zulässigen Wert gesunken ist. Die Logikschaltung 24 kann auch als eine Meldelogik ausgebildet sein, die beim Erreichen der kritischen Temperatur eine diesbezügliche Meldung an eine Überwachungsstelle überträgt, wie das durch den Pfeil 29 angedeutet ist. Der Betriebsstrom für die Logikschaltung 24 wird über die mit S und K verbundenen Anschlüsse 24a zugeführt.

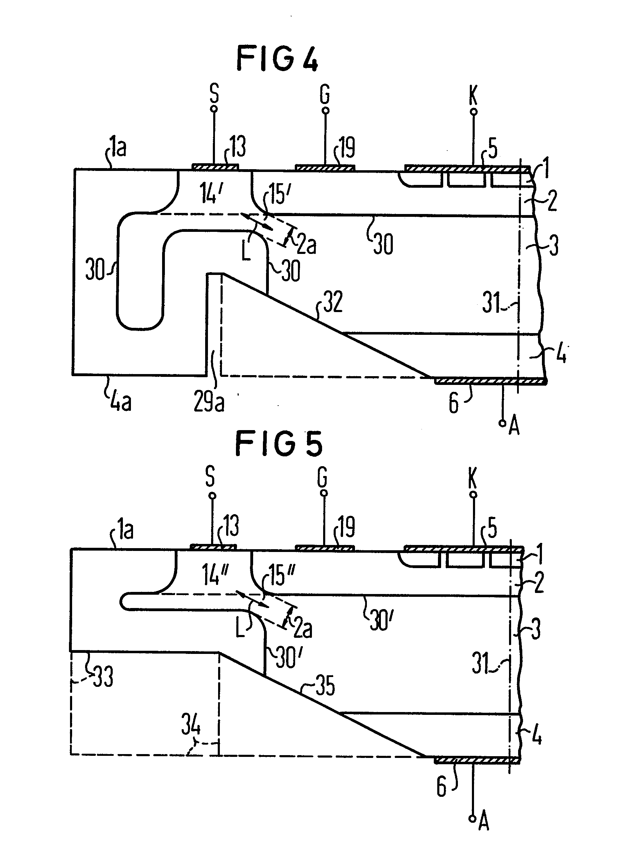

Die Herstellung der Thyristorstruktur nach den Figuren 1 und 3 erfolgt in herkömmlicher Weise durch eine Reihe von Diffusionsschritten, die unter Anwendung von Diffusionsmarken durchgeführt werden. Fig. 4 zeigt eine Modifikation dieser Thyristorstruktur, die einfacher hergestellt werden kann. Dabei wird von einer Scheibe aus n-dotiertem Halbleitermaterial, z.B. Silizium, ausgegangen. Vor der Durchführung einer die p-Basis 2 und den p-Emitter 4 erzeugenden, tiefen p-Diffusion wird die Grenzfläche 1a im Bereich der späteren Belegung 13 durch eine Diffusionsmaske abgedeckt und auf der anderen Scheibenseite eine von der Grenzfläche 4a ausgehende tiefe Kerbe 29a angebracht. Nach der p-Diffusion weist die Halbleiterscheibe randseitige p-Gebiete auf, die gegenüber dem inneren Scheibenteil durch die Linien 30 abgegrenzt sind. Anschließend folgt eine Eindiffusion des n-Emitters 1 in die p-Basis 2. Wird nun der gestrichelt gezeichnete Teil der Scheibe durch Abschrägen des anodenseitigen pn-Übergangs bis auf die Linie 32 entfernt, so entsteht eine Struktur, die im Prinzip der Thyristorstruktur nach Fig. 1 entspricht. Dem ersten Teil 14 des Ansatzes 12 von Fig. 1 entspricht im einzelnen der Teil 14', während der Kanal 15 von Fig. 1 durch den Teil 15' ersetzt wird, dessen Länge und Tiefe wieder mit L und 2a bezeichnet sind. Nach dem Aufbringen der Belegungen 13, 19, 5 und 6 können deren Anschlüsse S, G, K und A z.B. gemäß Fig. 1 oder Fig. 3 beschaltet werden.

Bei zylindersymmetrischer Ausbildung des Thyristors mit einer Symmetrieachse 31 kann auch die Kerbe 29a eine zylindrische Form haben. Verläuft die Kerbe dagegen geradlinig von Scheibenrand zu Scheibenrand, so muß der rechts von ihr liegende Teil des Scheibenrands soweit abgeschrägt werden, daß die seitliche Begrenzungsfläche durch den n-dotierten Scheibenbereich verläuft, der in radialer Richtung der Scheibe außerhalb des Teils 14' liegt.

Fig. 5 zeigt einen Thyristor, der auch in der vorstehend beschriebenen Weise hergestellt wird, jedoch mit der Abweichung, daß anstelle einer Kerbe 29a nunmehr ein von den Linien 33 und 34 begrenzter Teil der Halbleiterscheibe entfernt wird. Damit ergeben sich bei Durchführung der p-Diffusion randseitige p-Gebiete, die gegenüber dem Scheibeninneren durch die Linien 30' abgegrenzt sind. Wird dann der gestrichelt gezeichnete Teil der Halbleiterscheibe durch Abschrägen des anodenseitigen pn-Übergangs bis auf die Linie 35 entfernt, so entsteht wieder eine Struktur, die der nach Fig. 1 vergleichbar ist, wobei die Teile 14'' und 15'', letzteres mit der Länge L und der Tiefe 2a, den Teilen 14 und 15 entsprechen. Die Anschlüsse S, G, K und A können wieder z.B. gemäß Fig. 1 oder Fig. 3 beschaltet sein. Auch hier kann bei zylindersymmetrischer Ausbildung des Thyristors ein ringförmiger Teil der Scheibe entfernt werden, dessen Querschnitt durch 33, 34 begrenzt ist. Die Linie 35 deutet dann einen Teil einer Kegelfläche an. Wird jedoch ein Scheibenteil entfernt, der durch zwei senkrecht zur Bildebene liegende ebene Flächenteile begrenzt ist, die der horizontalen Linie 33 und der vertikalen Linie 34 entsprechen, so muß der rechts von der vertikalen Linie 34 liegende Teil des Scheibenrandes wieder so abgeschrägt werden, daß die seitliche Begrenzungsfläche durch den n-dotierten Scheibenbereich verläuft, der in radialer Richtung der Scheibe außerhalb des Teils 14'' liegt.

Im Rahmen der Erfindung liegen auch weitere Ausgestaltungen, bei denen eine Mehrzahl von Ansätzen 12 nebeneinander angeordnet und mit zugeordneten Belegungen 13 versehen sind. Dadurch wird der der Schaltungseinheit, z.B. 18 oder 24, maximal zuführbare Betriebsstrom vergrößert. Zwischen der Belegung 19 und dem n-Emitter 1 kann jeweils ein in herkömmlicher Weise ausgebildeter Hilfsemitter (amplifying gate) vorgesehen sein, der mit einer leitenden Belegung versehen ist, die den ihn begrenzenden pn-Übergang in der Fläche 1a in Richtung auf den n-Emitter 1 überragt.

An die Stelle der beschriebenen Schaltungseinheiten 18 und 24 können weiterhin beliebige andere, dem Thyristor zugeordnete Schaltungseinheiten treten, die jeweils mit Betriebsgrößen zu versorgen sind, welche über den Ansatz 12 aus dem Laststromkreis des Thyristors gewonnen werden. Hierzu gehören z.B. Logikschaltungen, die die Signale von auf unzulässige Anodenspannungen, Spannungsanstiegsgeschwindigkeiten oder Lastströme ansprechende Sensoren verarbeiten.

Bezugszeichenliste

1 n-Emitter
1a Grenzfläche
2 p-Basis
3 n-Basis
4 p-Emitter
4a Grenzfläche
5 kathodenseitige Elektrode
6 anodenseitige Elektrode
9 Anschluß von 10
10 Spannungsquelle
11 Anschluß von 10

12 Ansatz
13 leitende Belegung
14 erster Teil von 12
15 zweiter Teil von 12
16, 17 Ansätze der p-Basis 2
18 Schaltungseinheit
19 Zündelektrode
20 Fototransistor
21, 22 Anschlüsse von 20
23 pn-Übergang zwischen 12 und 2
24 Logikschaltung
24a Anschlüsse von 24
25 Temperatursensor
26 Leitung
27 elektronischer Schalter
28 Zündstromimpuls
29 Pfeil
29a Kerbe
30 Begrenzungslinien
31 Symmetrieachse
32 Abschrägungslinie
33, 34 Teil der Halbleiterscheibe
35 Abschrägungslinie
K Anschluß von 5
A Anschluß von 6
R Lastwiderstand
B1 Abmessung von 14
2a Tiefe des Teils 15
Z Weite des Teils 15
L Länge des Teils 15
S Anschluß von 13
G Anschluß von 19
D Übergang zwischen den Teilen 15 und 3

## Patentansprüche

1. Thyristor mit einem Halbleiterkörper, der einen von einer kathodenseitigen Elektrode (5) kontaktierten n-Emitter (1) mit einer angrenzenden p-Basis (2) und einen von einer anodenseitigen Elektrode (6) kontaktierten p-Emitter (4) mit einer angrenzenden n-Basis (3) aufweist, die ihrerseits an die p-Basis angrenzt, bei dem ein Ansatz (12) der n-Basis (3) die p-Basis (2) durchdringt, sich bis zu der die kathodenseitige Elektrode (5) tragenden Grenzfläche (1a) des Halbleiterkörpers erstreckt und in dieser mit einer leitenden Belegung (13) versehen ist, und bei dem die leitende Belegung (13) mit einem Anschluß einer dem Thyristor zugeordneten, mit Betriebsstrom zu versorgenden Schaltungseinheit (18) verbunden ist, **dadurch gekennzeichnet**, daß der Ansatz (12) der n-Basis (3) einen ersten, an der Grenzfläche liegenden und die leitende Belegung (13) tragenden Teil (14) und einen zweiten Teil (15) aufweist, der zwischen dem ersten (14) und der n-Basis (3) angeordnet ist, und daß die Querschnittsabmessungen des ersten Teiles (14) größer gewählt sind als die Abmessungen der leitenden Belegung (13) und als die Querschnittsabmessungen des zweiten Teiles (15), so daß die leitende Belegung mit der sich beim Auftreten von Blockierspannungen am pn-Übergang (23) zwischen dem Ansatz (12) und der p-Basis (2) ausbildenden Raumladungszone keinen Kontakt hat.

2. Thyristor nach Anspruch 1, **dadurch gekennzeichnet**, daß die Schaltungseinheit (18) ein lichtempfindliches Schaltungselement und einen nachgeschalteten Verstärker umfaßt, wobei die Schaltungseinheit (18) zwischen die leitende Belegung (13) und einen Anschluß (G) einer auf der p-Basis (2) angeordneten Zündelektrode (19) geschaltet ist.

3. Thyristor nach Anspruch 2, **dadurch gekennzeichnet**, daß das lichtempfindliche Schaltungselement aus einem Fototransistor (20) besteht.

4. Thyristor nach Anspruch 1, **dadurch gekennzeichnet**, daß die Schaltungsanordnung aus einer Logikschaltung (24) besteht, die mit einem das Betriebsverhalten des Thyristors überwachenden Sensor beschaltet ist, und daß ein Eingang (24a) der Logikschaltung (24), über den ein Betriebsstrom zugeführt wird, zwischen die leitende Belegung (13) und einen Anschluß (K) der kathodenseitigen Elektrode (5) geschaltet ist.

5. Thyristor nach Anspruch 4, **dadurch gekennzeichnet**, daß der Sensor die Temperatur des Thyristors überwacht und daß über den Ausgang der Logikschaltung (24) ein Schalter (27) betätigt wird, der eine die p-Basis (2) kontaktierende Zündelektrode (19) von einem Zündstromkreis abschaltet.

6. Verfahren zur Herstellung eines Thyristors nach einem der Ansprüche 1 bis 5, **dadurch gekennzeichnet**, daß von einer Halbleiterscheibe aus n-dotiertem Halbleitermaterial ausgegangen wird, daß unter Verwendung einer den Bereich oberhalb des zu bildenden Ansatzes (12) der n-Basis (3) auf der kathodenseitigen Grenzfläche (1a) abdeckenden Dotierungsmaske und unter vorheriger Anbringung einer dem Ansatz (12) etwa gegenüberliegenden, von der anodenseitigen Grenzfläche (4a) ausgehenden tiefen Kerbe (29a) eine tiefe Diffusion durchgeführt wird, die die p-Basis und den p-Emitter erzeugt, daß der n-Emitter (1) in die p-Basis eingefügt wird und daß der anodenseitige pn-Übergang so weit abgeschrägt wird, daß der von den Seitenflächen der Kerbe (29a) ausgehende p-dotierte Halbleiterbereich keine leitende Verbindung zum p-Emitter aufweist.

7. Verfahren zur Herstellung eines Thyristors nach einem der Ansprüche 1 bis 5, **dadurch gekennzeichnet**, daß von einer Halbleiterscheibe aus n-dotiertem Halbleitermaterial ausgegangen wird, daß unter Verwendung einer den Bereich oberhalb des zu bildenden Ansatzes (12) der n-Basis (3) auf der kathodenseitigen Grenzfläche (1a) abdeckenden Dotierungsmaske und unter vorheriger Entfernung eines dem Ansatz (12) etwa gegenüberliegenden Teiles des Halbleiterkörpers eine tiefe p-Diffusion durchgeführt wird, die die p-Basis und den p-Emitter erzeugt, daß der n-Emitter (1) in die p-Basis (2) eingefügt wird und daß der anodenseitige pn-Übergang so weit abgeschrägt wird, daß der von der durch die Entfernung des genannten Teiles entstandenen Ausnehmung (33, 34) ausgehende p-dotierte Halbleiterbereich keine leitende Verbindung zum p-Emitter (4) aufweist.

FIG 1

FIG 2

# FIG 3

0230278

## FIG 4

## FIG 5